(19) Europäisches Patentamt
European Patent Office
Office européen des brevets

(11) EP 4 503 259 A1

(12) **EUROPEAN PATENT APPLICATION**
published in accordance with Art. 153(4) EPC

(43) Date of publication:
05.02.2025 Bulletin 2025/06

(51) International Patent Classification (IPC):
$H01M\ 10/48^{(2006.01)}$    $B60L\ 3/00^{(2019.01)}$
$B60L\ 58/24^{(2019.01)}$

(21) Application number: 23781106.2

(22) Date of filing: 31.03.2023

(52) Cooperative Patent Classification (CPC):
B60L 3/00; B60L 58/24; H01M 10/48; Y02E 60/10

(86) International application number:
PCT/JP2023/013710

(87) International publication number:
WO 2023/191098 (05.10.2023 Gazette 2023/40)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 31.03.2022 JP 2022061424

(71) Applicant: Vehicle Energy Japan Inc.
Ibaraki 312-8505 (JP)

(72) Inventor: IMAI, Shinji
Tokyo 100-8280 (JP)

(74) Representative: MERH-IP Matias Erny Reichl
Hoffmann
Patentanwälte PartG mbB
Paul-Heyse-Straße 29
80336 München (DE)

(54) **BATTERY CONTROL DEVICE**

(57) Provided is a battery control device that calculates at least temperature information T to calculate allowable power of a battery, the battery control device including: a surface temperature detection unit that measures a surface temperature Ts of the battery; an internal temperature calculation unit that estimates an estimated internal temperature Ti of the battery in place of the actual measurement; and a temperature selection unit that selects and outputs either the surface temperature Ts or the estimated internal temperature Ti as the temperature information T, wherein based on information accumulated for more than one clock time, the information being taken at a certain clock time and being of an actual charge/discharge voltage Vm of the battery, an actual charge/discharge current I of the battery, and an estimated charge/discharge voltage Ve that Is estimated from state information of the battery, the temperature selection unit determines a magnitude relationship between a true internal temperature Tt, the surface temperature Ts, and the estimated internal temperature Ti for the current battery, and applies the selected temperature information T to control according to a result of the judgement. Thus, the provided battery control device allows the battery to be used safely and offer its performance at the same time.

FIG. 4

**Description**

[Technical Field]

The present invention relates to a battery control device.

[Background Art]

In storage battery systems, or battery systems, which continuously operate batteries, the system is controlled based on the battery temperature. However, since it is not easy to measure the temperature inside a battery, conventional systems measure the temperature on the surface of the battery with sensors and estimate the temperature inside the battery based on the measurement results.

Moreover, the electrical characteristics of a battery is essentially dependent on the true internal temperature $T_t$, while conventional control using the surface temperature $T_s$, which is a value lower than $T_t$, excessively limits the original allowable power. In order to eliminate the error caused by control using the surface temperature $T_s$, there is a technique in which the true internal temperature $T_t$, which represents the essential characteristics of the battery, is estimated and used for battery control.

Thus, for safe power regulation, a technique is known that calculates the true internal temperature $T_t$ from, in addition to the surface temperature $T_s$, the current value, ambient temperature, and cooling air flow rate (see Patent Literature 1, for example) rather than using the surface temperature $T_s$.

There is also a known technique that calculates the difference between the actual measured surface temperature $T_s$ obtained from a temperature sensor and the temperature obtained from a battery temperature model, and makes a correction to reduce this difference to zero for using highly accurate temperature information T for battery control (see Patent Literature 2, for example).

[Citation List]

[Patent Literature]

[Patent Literature 1]
Japanese Patent Laid-Open No. 2011-222133
[Patent Literature 2]
Japanese Translation of PCT International Application Publication No. 2014-531711

[Summary of Invention]

[Technical Problem]

However, an estimated internal temperature $T_i$ obtained by the techniques described in Patent Literatures 1 and 2 above has a problem with errors due to accuracy limitations, and if the accuracy of the estimated internal temperature $T_i$ of the battery by calculation is low, the battery controlled based thereof is disadvantageous in terms of unnecessary limitation on originally intended capabilities, reduced service life, and safety reliability.

If the calculated estimated internal temperature $T_i$ is higher than the true value, the allowable power limit, which is to be changed depending on the temperature, will be set higher than an intended value to be set, so that ideally desirable power control cannot be achieved. It is therefore necessary to check whether the estimated internal temperature $T_i$ that has been estimated and calculated has been correctly calculated.

Besides, it is required to determine which of the directly measurable surface temperature $T_s$ or the estimated internal temperature $T_i$ that has been estimated is more appropriate for control to use in the condition detecting calculation, and to switch the temperature information used according to the situation. An object of the present invention, which has been made in view of the aforementioned problems, is to propose a battery control device that enables the battery to be safely used and to offer performance at the same time.

[Solution to Problem]

In order to solve the aforementioned problem, provided is a battery control device of the present invention that calculates at least temperature information T to calculate allowable power of a battery, the battery control device including:

a surface temperature detection unit that actually measures a surface temperature Ts of the battery; an internal temperature calculation unit that estimates an estimated internal temperature Ti of the battery in place of the actual measurement; and a temperature selection unit that selects and outputs either the surface temperature Ts or the estimated internal temperature Ti as the temperature information T, wherein based on information accumulated for more than one clock time, the information being taken at a certain clock time and being of an actual charge/discharge voltage Vm of the battery, an actual charge/discharge current I of the battery, and an estimated charge/discharge voltage Ve that is estimated from state information of the battery, the temperature selection unit determines a magnitude relationship between a true internal temperature Tt, the surface temperature Ts, and the estimated internal temperature Ti for the current battery, and applies the selected temperature information T to control according to a result of the judgement.

[Advantageous Effect of Invention]

The present invention provides a battery control device that enables a battery to be safely used and to offer performance at the same time.

[Brief Description of Drawings]

[Figure 1] Figure 1 is a functional block diagram for explaining a battery control device (hereinafter also referred to as "the present battery control device") according to an embodiment of the present invention, and covers a storage battery system and its peripherals that are subject to its control.
[Figure 2] Figure 2 is a functional block diagram showing a circuit configuration of a single-battery control unit that constitutes a single-battery management unit in the storage battery system shown in Figure 1.
[Figure 3] Figure 3 is a functional block diagram showing the schematic configuration of a temperature information processing unit that constitutes the assembled battery control unit shown in Figures 1 and 2.
[Figure 4] Figure 4 is a functional block diagram showing the configuration of the assembled battery control unit shown in Figures 1 to 3, and also clearly shows the temperature selection unit.
[Figure 5] Figure 5 shows an example of a battery equivalent circuit for explaining the processing in a CCV calculation unit shown in Figure 4.
[Figure 6] Figure 6 is a graph illustrating behaviors of an estimated charge/discharge voltage (hereinafter also referred to as "estimated voltage") Ve and an actual charge/discharge voltage (hereinafter also referred to as "measured voltage") Vm for each pattern of magnitude relationship between the estimated internal temperature Ti and the true internal temperature Tt (hereinafter also referred to as "temperature magnitude relationship pattern" or "temperature pattern") to be input to the CCV calculation unit shown in Figure 4.
[Figure 7] Figure 7 is a flowchart illustrating the processing in a pattern judgement unit which constitutes the temperature selection unit shown in Figure 3.
[Figure 8] Figure 8 is a graph schematically illustrating the processing in the pattern judgement unit shown in Figure 4.
[Figure 9] Figure 9 is a table illustrating the data held by a pattern holding unit that constitutes the temperature selection unit shown in Figures 1 to 4.

[Description of Embodiment]

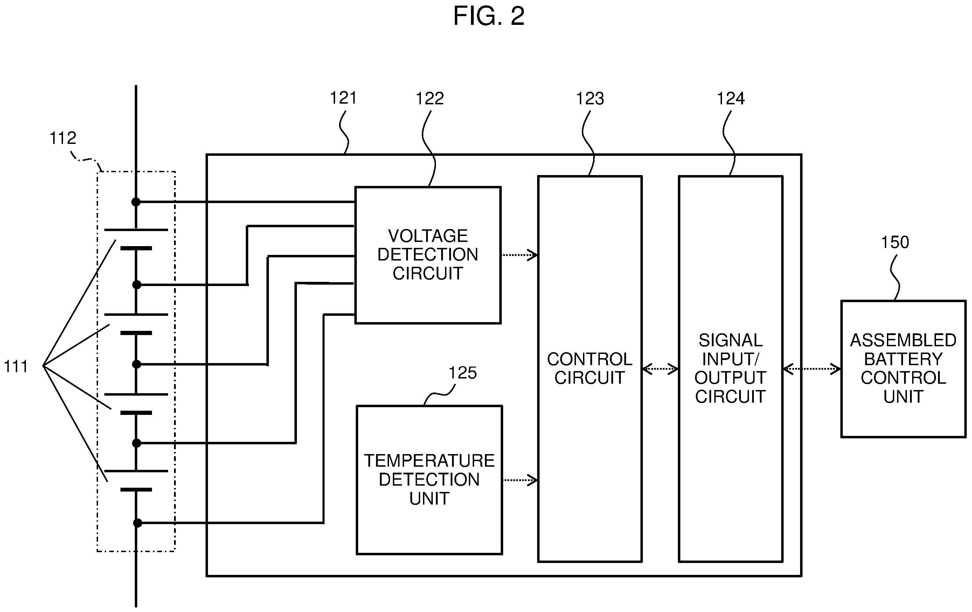

The configuration and operation of the present battery control device will be described below with reference to the drawings. In each drawing, the same reference sign represents the same part. The present battery control device is suitable for plug-in hybrid vehicles equipped with a storage battery system 100, which case will be described below. However, the present battery control device can also be applied to other hybrid vehicles and electric vehicles.

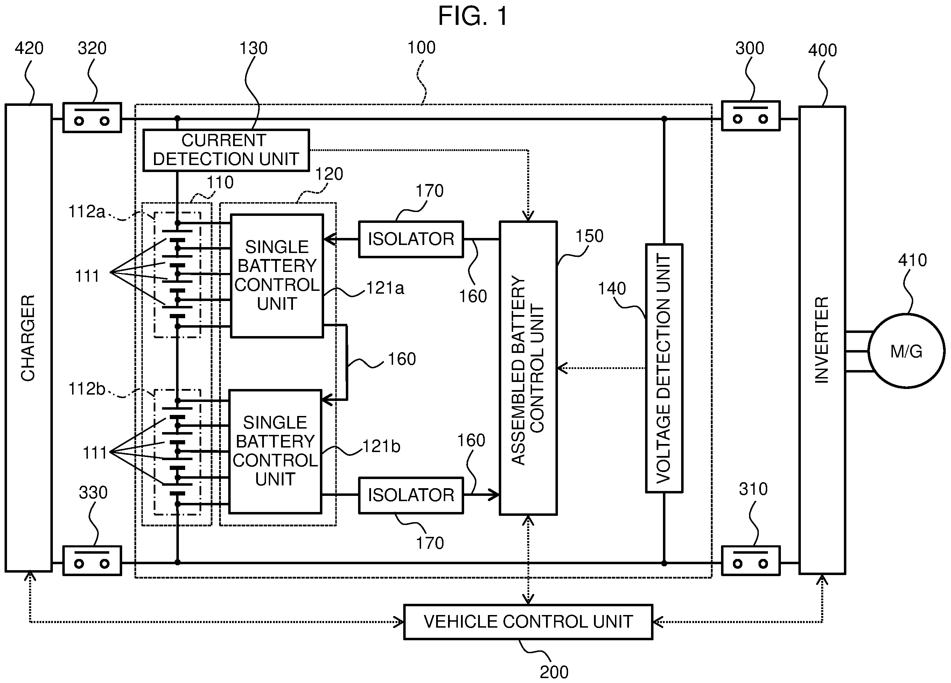

Figure 1 is a functional block diagram for explaining the present battery control device (not denoted by a reference sign). The present battery control device includes a storage battery system 100 and its peripherals (denoted by the reference signs 200 to 420) which are subject to its control. The storage battery system 100 is coupled to the inverter 400 via the relays 300 and 310 and to the charger 420 via the relays 320 and 330.
The storage battery system 100 includes an assembled battery 110, a single battery management unit 120, a current detection unit 130, a voltage detection unit 140, an assembled battery control unit 150, and a memory unit not shown in the drawing. The assembled battery control unit 150, together with the charger 420 and inverter 400, is subject to overall control, while exchanging information with the higher-level vehicle control unit 200. The vehicle control unit 200 is used in the case where the present battery control device is applied to an automobile, and may be in another form.
There is no particularly substantial distinction between the present battery control device and the storage battery system 100, and many of the components of each functional block shown in Figure 1 belong to both. For the sake of convenience of explanation, different expressions are used here to make a conceptual distinction between the battery control device, which has a computer at its core and constitutes the control entity, and the storage battery system 100, which includes single battery groups 112a and 112b (112 as shown in Figure 2 if distinction is unnecessary) and their peripheral equipment, which are to be controlled by the battery control device.

The assembled battery 110 includes a plurality of single batteries 111 that can store and release electrical energy (charge and discharge of DC power) and are electrically connected in series. The single batteries 111 constituting the assembled battery 110 are grouped into a predetermined number of units for implementing state management and control.

The grouped single batteries 111 are electrically connected in series to form single battery groups 112a and 112b (112 when not distinguished). The number of single batteries 111 constituting the single battery groups 112 may be the same for all single battery groups 112, or the number of single batteries 111 may be different for each single battery group 112.

The single battery management unit 120 monitors the state of the single batteries 111 that constitute the assembled battery 110. The single battery management unit 120 includes a single battery control unit 121 provided for each single battery group 112. In Figure 1, single battery control units 121a and 121b (collectively 121) are provided corresponding to the single battery groups 112a and 112b. Each single battery control unit 121 monitors and controls the state of the single batteries 111 constituting the corresponding single battery group 112.

Note that in the present battery control device, for simplicity of explanation, four single batteries 111 are electrically connected in series to form the single battery groups 112a and 112b, and the single battery groups 112a and 112b are further electrically connected in series to form the assembled battery 110 with a total of eight single batteries 111.

Moreover, the single battery groups 112a and 112b, which are collectively referred to as an assembled battery 110, is also called a battery 110 when considered as a single power source. The assembled battery 110 includes a plurality of single batteries 111. The single battery management unit 120 monitors the state of the single batteries 111. The current detection unit 130 detects the current flowing in the storage battery system 100.

The voltage detection unit 140 detects the overall voltage of the assembled battery 110. The assembled battery control unit 150 has a function of acquiring indicators representing the state of the assembled battery 110 to detect the state, and optimally controlling it according to the state. The various indicators will be described below.

The assembled battery control unit 150 receives the battery voltage and temperature of each single battery 111 transmitted by the single battery management unit 120, the value of the current flowing in the storage battery system 100 transmitted by the current detection unit 130, and the value of the overall voltage of the assembled battery 110 transmitted by the voltage detection unit 140. The assembled battery control unit 150 detects the state of the assembled battery 110 based on the received information. The results of the state detection by the assembled battery control unit 150 are transmitted to the single battery management unit 120 and the vehicle control unit 200.

The assembled battery control unit 150 and the single battery management unit 120 transmit and receive signals via an insulator 170, represented by a photocoupler, and signal communication means 160. The reason that the insulator 170 is provided is because the assembled battery control unit 150 and the single battery management unit 120 have different operating power sources.

In other words, the single battery management unit 120 operates on power from the assembled battery 110, whereas the assembled battery control unit 150 uses a battery for onboard auxiliary equipment (e.g., 14 V system battery, not shown) as a power source.

The insulator 170 may be mounted on a circuit board constituting the single battery management unit 120 or on a circuit board constituting the assembled battery control unit 150. Depending on the system configuration, the insulator 170 may be omitted.

The communication means between the assembled battery control unit 150 and the single battery control units 121a and 121b, which constitute the single battery management unit 120, will be described below. The single battery control units 121a and 121b are connected in series in descending order of potential of the single battery groups 112a and 112b that they respectively monitor. Signals sent by the assembled battery control unit 150 to the single battery management unit 120 are input to the single battery control unit 121a via the insulator 170 and the signal communication means 160.

The output of the single battery control unit 121a is input to the single battery control unit 121b via the signal communication means 160, and the output of the lowest-level single battery control unit 121b is transmitted to the assembled battery control unit 150 via the insulator 170 and signal communication means 160. In the present battery control device, the insulator 170 is not interposed between the single battery control unit 121a and the single battery control unit 121b, but signals can be transmitted and received therebetween via the insulator 170.

The memory unit stores information about the internal resistance characteristics, capacity at full charge, polarization characteristics, degradation characteristics, individual difference information, and characteristics of the charge rate (state of charge (SOC)) and open circuit voltage OCV (open circuit voltage or off-load voltage) of the assembled battery 110, single batteries 111, and single battery groups 112.

Although the memory unit in the present battery control device has been illustrated as being installed outside of the assembled battery control unit 150 or the single battery management unit 120, this is not necessarily the case. This memory unit may be configured to be provided in the assembled battery control unit 150 or the single battery management unit 120, and the aforementioned information may be stored in it.

The vehicle control unit 200 controls the inverter 400 coupled to the storage battery system 100 via the relays 300 and 310 using the information transmitted by the assembled battery control unit 150. It also controls the charger 420 coupled to the storage battery system 100 via the relays 320 and 330.

If the storage battery system 100 and the present battery control device are applied to objects other than a vehicle system, the vehicle control unit 200, including its designation, will be replaced with a corresponding one. Here, explanations of non-vehicle applications are omitted.

When the vehicle is running, the storage battery system 100 is coupled to the inverter 400 and uses the energy stored in the assembled battery 110 to drive the motor generator 410. In charging, the storage battery system 100 is coupled to the charger 420 and is charged by a household power source or a power supply from a charging station.

The charger 420 is used to charge the assembled battery 110 using an external commercial power source (external power source) represented by a household power source or a charging station. In the present battery control device, the charger 420 is configured to control the charging voltage, charging current, and the like according to commands from the vehicle control unit 200, but it may also control similarly according to commands from the assembled battery control unit 150. Thus, in the present battery control device, there is no strict distinction in function sharing between the assembled battery control unit 150 and the vehicle control unit 200.

The charger 420 can be provided inside the vehicle or outside the vehicle, depending on its performance, its intended use, the configuration of the vehicle to which it is applied, or the installation conditions of the external power source. In other words, there is no limitation on the assignment or location of each functional part, and their designations are also acceptable as long as their respective functions can be distinguished.

When a vehicle system equipped with the storage battery system 100 and the present battery control device starts and runs, the present battery control device controls the storage battery system 100 under the control of the vehicle control unit 200 at a higher control tier. The storage battery system 100 is coupled to the inverter 400 and drives the motor generator 410 using the energy stored in the assembled batteries 110, and during regeneration, the assembled battery 110 is charged by the power generated by the motor generator 410.

When a vehicle equipped with the storage battery system 100 is coupled to an external power source represented by a household power source or a charging station, the charger 420 is coupled to the storage battery system 100 based on information transmitted by the vehicle control unit 200, and the assembled battery 110 is charged until it reaches a predetermined condition.

The energy stored in the assembled battery 110 by charging is used the next time the vehicle is running or used to operate electrical and other components inside and outside the vehicle. Furthermore, if necessary, it may be released as a backup power source for household power source.

Figure 2 is a functional block diagram showing the circuit configuration of the single battery control unit 121, which constitutes the single battery management unit 120 in the storage battery system 100 shown in Figure 1. The single battery control unit 121 includes a voltage detection circuit 122, a control circuit 123, a signal input/output circuit 124, and a temperature detection unit 125.

The voltage detection circuit 122 measures the voltage between the terminals of each single battery 111. The control circuit 123 receives the measurement results from the voltage detection circuit 122 and the temperature detection unit 125 and transmits them to the assembled battery control unit 150 via the signal input/output circuit 124.

Note that examples of circuit configurations commonly implemented in the single battery control unit 121 include circuits that equalize the voltage between the single batteries 111 and the SOC variations that occur due to self-discharge and consumption current variations. These circuits are considered to be well known and have been omitted from the description.

The temperature detection unit 125 provided in the single battery control unit 121 shown in Figure 2 has a function of measuring the temperature of the single battery group (battery) 112. The temperature detection unit 125 measures one temperature for the single battery group 112 as a whole and treats it as a temperature representative value for the individual temperatures of the single batteries 111 that constitute the single battery group 112.

The temperature measured by the temperature detection unit 125 is used in various calculations to obtain an index for detecting the state of the single battery 111, single battery group 112, or assembled battery 110. Referring to Figure 2, which is based on that assumption, one temperature detection unit 125 is provided in the single battery control unit 121.

Although it is possible to provide a temperature detection unit 125 for each single battery 111 to measure the temperature of each single battery 111 and perform various calculations based on the individual temperature of each single battery 111, this case makes the configuration of the single battery control unit 121 more complex because of the larger number of temperature detection units 125.

Figure 2 shows the temperature detection unit 125 for simplicity. In reality, a temperature sensor (not shown in the drawing) is installed on the temperature measurement target. That installed temperature sensor outputs temperature information in the form of a voltage, which is measured and is sent to the signal input/output circuit 124 via the control circuit 123. That signal input/output circuit 124 outputs the measurement results outside the single battery control unit 121.

The function to realize this sequence of steps is implemented in the single battery control unit 121 as a temperature detection unit 125, and a voltage detection circuit 122 may be used to measure temperature information (voltage). In the present battery control device, the temperature sensor is assumed to be installed on the surface of the battery and measure the surface temperature Ts of the battery. In other words, the temperature detection unit 125 functions as a surface temperature detection unit that actually measures the surface temperature Ts of the battery.

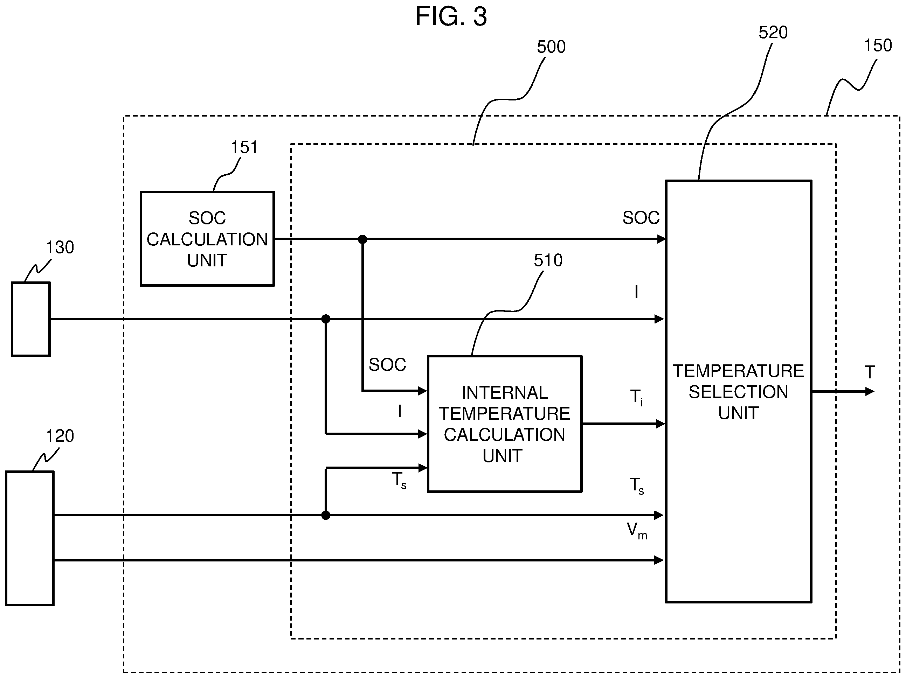

Figure 3 shows the assembled battery control unit 150 according to the present invention and its component, a temperature information processing unit 500. The assembled battery control unit 150 is a part that determines the condition and allowable power of the assembled battery based on the current value, voltage value, and temperature of the assembled battery while the vehicle is running, and the temperature information processing unit 500 is its component.

The assembled battery control unit 150 includes battery degradation rate state of health (SOH), SOC, OCV calculation and an allowable power calculation unit. However, for the sake of brevity of the explanation of the present invention, only the SOC calculation unit 151 and temperature information processing unit 500, which are related to the present invention, will be described below one by one. The SOC calculation unit 151 calculates the SOC of each single battery 111. Equation (1) is an example of the calculation equation used in the SOC calculation unit 151 to calculate the SOC.

[Formula 1]

$$SOC(t) = SOC_0 + 100 \cdot \frac{\int I(t)dt}{Q_{max}} \qquad \cdots (1)$$

SOC(t) is the SOC at the time t, $SOC_0$ is the SOC in the initial state of a single battery 111 before charging and discharging, I(t) is the current flowing in the single battery 111 at the time t, and Qmax is the fully charged capacity of the single battery 111. $SOC_0$ is estimated based on the voltage between the terminals measured before the single battery 111 is charged and discharged.

The characteristic data showing the relationship between the pre-measured SOC and electromotive force OCV of the single battery 111 are stored in the memory unit mentioned above, and the initial SOC of the single battery 111 is estimated as $SOC_0$ based on the battery voltage measured at a point of time before charging/discharging when the voltage of the single battery 111 can be considered equal to the electromotive force OCV.

Qmax is experimentally determined by charging and discharging the single battery 111, and the value prestored in the memory unit is also used. The SOC calculation unit 151 may calculate the SOC of each of the multiple single batteries 111 individually using the method described above, or may calculate a single SOC for the assembled battery 110 as a whole. In that case, the initial SOC can be determined based on the total voltage obtained from the voltage detection unit 140 and the characteristic data of SOC and OCV considering the number of series of single batteries 111.

The temperature information processing unit 500 will now be described. The temperature information processing unit 500 includes an internal temperature calculation unit 510 and a temperature selection unit 520 which are contained therein. These operations will be described one by one. The internal temperature calculation unit 510 estimates and calculates the internal temperature of the battery, using the SOC of the battery transmitted from the SOC calculation unit 151, the actual charge/discharge current I transmitted from the current detection unit 130, and the battery surface temperature Ts measured by the temperature sensor as input information, and outputs it as the estimated internal temperature Ti.

Although there are various schemes for calculating and estimating the internal temperature, an example case of using the thermal network method will be described for the present battery control device. Equation (2) expresses the estimated internal temperature Ti (t) at the time t calculated by the internal temperature calculation unit 510 as a function f.

[Formula 2]

$$T_i(t) = f\{T_i(t - \Delta t), T_s(t), Q_{gen}(t), \Delta t\} \qquad \cdots (2)$$

The function f in Equation (2) is defined by the thermal network method. The thermal network method is a scheme in which the thermal system to be modeled is expressed by the transfer of a quantity of heat between simplified multiple material points. The amount of heat transferred is determined by the temperature difference between the two points and the thermal resistance, and the amount of heat transferred or generated is conserved as the amount of heat to be used to raise the temperature of the material points in the entire system.

Δt in Equation (2) is the time interval for calculating the internal temperature and is a predefined value. Ts(t) is the battery surface temperature Ts measured by the temperature sensor. Ti(t - Δt) is the internal temperature calculated one calculation step before, but the temperature sensor-measured temperature Ts is used for the first calculation just after the battery system startup. Qgen(t) is the amount of heat generated between the time t - Δt and the time t, and is defined by the following equation (3).

[Formula 3]

$$Q_{gen}(t) = \int_{t-\Delta t_0}^{t} R(SOC(t), T_i(t - \Delta t))I(t)^2 dt \quad \cdots (3)$$

Here, R is the internal resistance of the battery. It is known that the internal resistance of a battery depends on the SOC and battery temperature. Here, the internal temperature does not necessarily refer to that of only one point inside the battery, but includes temperatures to be calculated inside and outside the battery used for the function f. For example, in the thermal circuit model, besides the central material point inside the battery, the function f includes material points on the surface of the battery and material points in components outside the battery, whose temperatures can also be calculated by the thermal circuit model.

Performing the judgement operation described below, the temperature selection unit 520 selects and outputs either one of the two types of input temperature information T, the estimated internal temperature Ti and the battery surface temperature Ts. The temperature selection unit 520 uses as input information the actual charge/discharge current I, the battery surface temperature Ts and measured voltage Vm transmitted from the single battery management unit 120, and the SOC output from the SOC calculation unit 151 described above, and outputs them as temperature information T. For the measured voltage Vm, a closed circuit voltage (CCV or on-load voltage) is mainly used. The details of this temperature selection unit 520 will be described below.

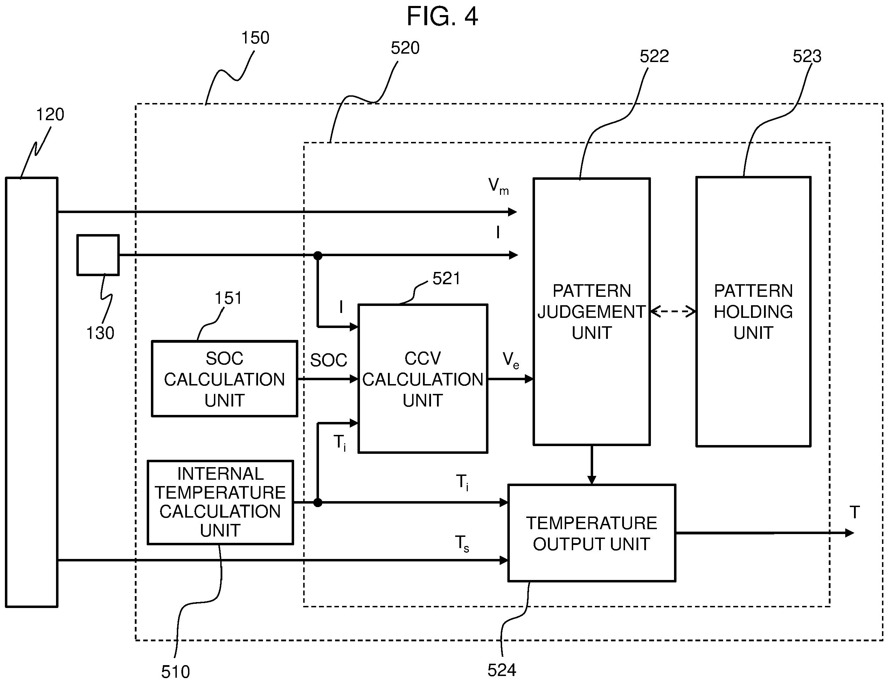

Figure 4 is a functional block diagram showing the configuration of the assembled battery control unit 150 shown in Figures 1 to 3, and clearly shows the temperature selection unit 520. The temperature selection unit 520 includes a CCV calculation unit 521, a pattern judgement unit 522, a pattern holding unit 523, and a temperature output unit 524, all of which are contained therein. The CCV calculation unit 521 calculates the estimated voltage Ve, using the actual charge/-discharge current I, estimated internal temperature Ti, and battery charge rate, and SOC.

The pattern judgement unit 522 inputs the measured voltage Vm, which is the actual measured battery voltage, the actual charge/discharge current I, and the aforementioned battery voltage calculation value, i.e., estimated voltage Ve, and judges the temperature pattern by referring to the pattern information held in the pattern holding unit 523 which is described below. The judgement result is then output to the temperature output unit 524 described below.

The details of how the CCV calculation unit 521 calculates the estimated voltage Ve will be described below. The pattern judgement unit 522 uses as inputs the measured voltage Vm, which is the actual measured battery voltage, the actual charge/discharge current I, and the battery voltage calculation value, i.e., estimated voltage Ve, and refers to the temperature pattern information received from the pattern holding unit 523 described below, and transmits information about the temperature to be selected to the temperature output unit 524.

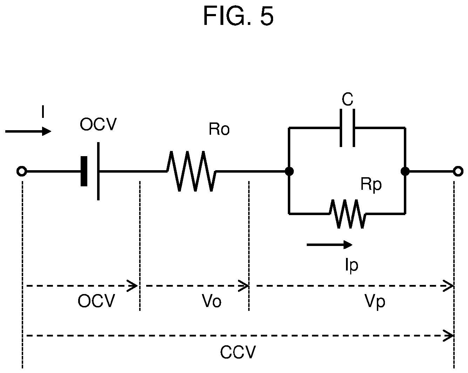

The temperature output unit 524 selects either the estimated internal temperature Ti or the battery surface temperature Ts and outputs it as temperature information T according to a command from the pattern judgement unit 522. First, the operation of the CCV calculation unit 521 will be explained. The CCV calculation unit 521 estimates the voltage (CCV) between the terminals of a single battery 111 during charging and discharging based on the concept of the battery equivalent circuit model shown in Figure 5.

Figure 5 is an example of a battery equivalent circuit for explaining the processing in the CCV calculation unit 521 shown in Figure 4, and OCV represents the electromotive force that varies according to SOC and Ro represents the DC resistance component including the member resistance of the electrodes. An operation in which the battery voltage fluctuates transiently with a certain time constant due to charging and discharging is represented by a parallel circuit of Rp and C.

Here, Rp is called polarization resistance and C is called polarization capacitance, and the transient response time constant of the parallel part of Rp and C is defined as τ. If the voltage applied to Ro when the actual charge/discharge current I is applied to the battery is Vo, and the polarization voltage applied to the polarization resistor Rp and the polarization capacitance C is Vp, then the voltage between the battery terminals, CCV, is expressed as in Equation (4).

[Formula 4]

$$CCV = OCV + IR_o + V_p \quad \cdots (4)$$

The polarization voltage Vp is calculated by Equation (5).

[Formula 5]

$$V_p = \frac{t_s}{\tau}IR_p + \left(1 - \frac{t_s}{\tau}\right)V_{p\_z} \qquad \cdots (5)$$

While ts is the calculation cycle, Vp is calculated every time Ts. Moreover, Vp_z in Equation (5) is the polarization voltage calculated one calculation cycle before. The CCV calculation unit 521 estimates and calculates the voltage of the single battery 111 based on Equations (4) and (5). However, as described above, the OCV is determined from the characteristic data of SOC and OCV, which is held in advance according to the input SOC.

Since the equivalent circuit parameters of Ro, Rp, and $\tau$ also vary depending on the SOC, temperature, and current of the battery, the characteristic data of Ro, Rp, and $\tau$, which have been experimentally determined in advance, are stored in the memory unit and used at the time of calculation of CCV. These types of characteristic data are referred to for the purpose of, in particular, improving the relationship between temperature error and deterioration of control accuracy.

Suppose here that the temperature used by the CCV calculation unit 521 to estimate the voltage CCV between the terminals of the single battery 111 is the estimated internal temperature Ti of the battery estimated by the internal temperature calculation unit 510 described above. The magnitude relationship between the estimated internal temperature Ti and the true internal temperature Tt of the single battery 111 and the estimated voltage (estimated charge/discharge voltage) Ve will be taken below. Here, the true internal temperature Tt is equivalent to the battery's surface temperature Ts measured under conditions where the temperature from the surface to the center of the battery can be considered uniform.

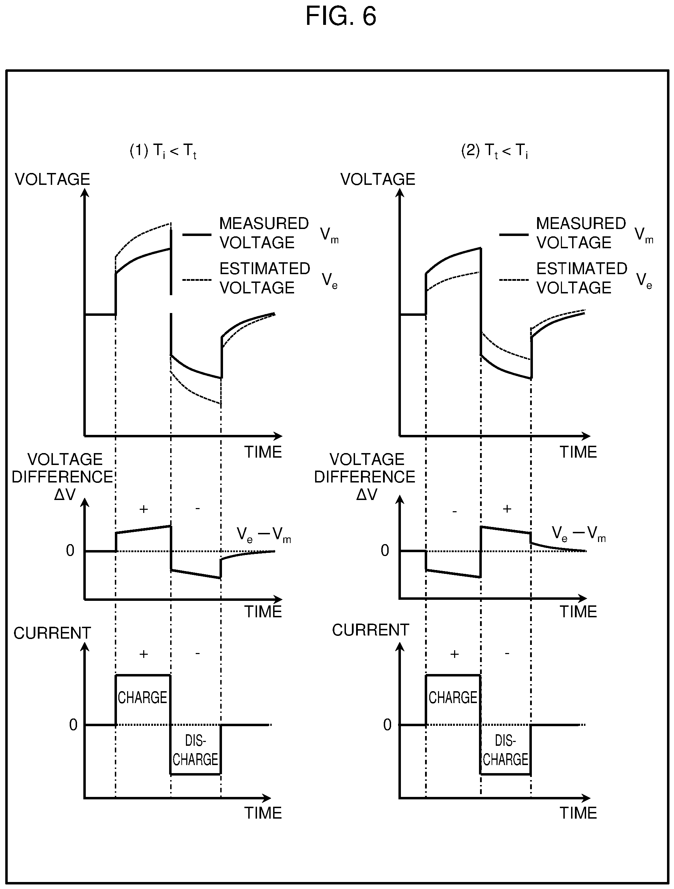

Figure 6 is a graph illustrating the behaviors of the estimated voltage Ve, which is estimated by calculation, and the measured voltage (actual charge/discharge voltage) Vm, which is actually measured, in different patterns of magnitude relationship (temperature patterns) between the estimated internal temperature Ti and the true internal temperature Tt which is input to the CCV calculation unit shown in Figure 4.

The internal temperature calculation unit 510 estimates and calculates the internal temperature of the single battery 111, but the estimated temperature does not always exactly match the true internal temperature Tt because the calculation contains errors. Therefore, the estimated internal temperature Ti and the true internal temperature Tt are expected to be in a magnitude relationship of either Ti < Tt shown in Figure 6(1) or Tt < Ti shown in Figure 6(2).

The graph inFigure 6(1) shows changes in voltage, voltage difference, and current over time when the relationship is Ti < Tt. The upper graph in Figure 6(1) shows the measured voltage Vm and the estimated voltage Ve calculated by the CCV calculation unit 521, where the solid line represents the measured voltage Vm and the dashed line represents the estimated voltage Ve. The middle graph in the drawing shows the difference ΔV between the estimated voltage Ve and the measured voltage Vm (ΔV = Ve - Vm). The lower graph in the drawing shows the current flowing in the battery, with positive polarity defined as charge and negative polarity as discharge.

When Ti < Tt shown in Figure 6(1), i.e., the estimated internal temperature Ti is lower than the true internal temperature Tt, a value of temperature lower than the actual one is input to the CCV calculation unit 521 as the estimated internal temperature Ti. The CCV calculation unit 521 will then refer to the original value, i.e., the value corresponding to the estimated internal temperature Ti that is lower than the true internal temperature Tt, as the value of the equivalent circuit parameter used when the estimated voltage Ve of the battery is calculated.

Since batteries are generally known to have higher internal resistance and longer transient response times at lower temperatures, the values of Ro, Rp, and $\tau$ shown in the equivalent circuit in Figure 5 are larger than their original values when used for CCV calculation.

Therefore, as derived from the relationship between Equations (4) and (5), if values larger than actual ones are used as each equivalent circuit parameter, the calculated CCV is higher during charging, whereas the calculated CCV is lower during discharging. This situation is shown in the upper graph in Figure 6(1).

Here, attention will be focused on the relationship between the voltage difference ΔV shown in the middle graph in Figure 6(1), the current in the lower graph in the same drawing, and the sign indicating which is positive or negative (hereinafter referred to as "positive/negative sign"). In the present battery control device, the voltage difference ΔV is defined as (Ve - Vm). ΔV does not take an absolute value, so it can be either positive or negative.

As shown in Figure 6(1), ΔV takes a positive (+) value during charging and a negative (-) value during discharging, so if the estimated internal temperature Ti is lower than the true internal temperature Tt as in Figure 6(1), the positive/negative sign of the current and the positive/negative sign of the voltage difference ΔV are identical.

Next, the case where Tt < Ti in Figure 6(2) is taken. In this case, on the contrary to the case of Figure 6(1) above, when the CCV calculation unit 521 calculates the battery voltage, each equivalent circuit parameter used is a value smaller than the actual one. Therefore, the magnitude relationship between the estimated voltage Ve and the measured voltage Vm during charging and discharging is opposite to that in Figure 6(1).

Therefore, focusing on the positive/negative signs of the voltage difference ΔV and current, as shown in Figure 6(2), ΔV is negative during charging, i.e., when the current is positive, and ΔV is positive during discharging, i.e., when the current is negative.

In other words, as shown in Figure 6(2), when the estimated internal temperature Ti is higher than the true internal temperature Tt, the positive/negative sign of the current and the positive/negative sign of the voltage difference ΔV are opposite. Based on this concept of the current and voltage difference and the combination of their positive/negative signs, the subsequent operation of the pattern judgement unit 522 will be explained.

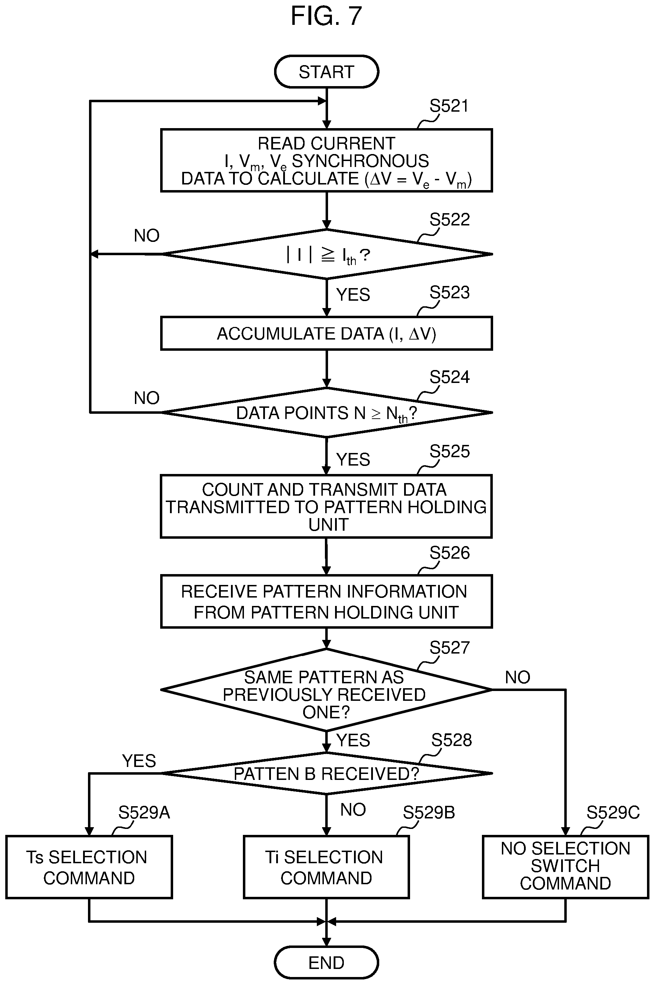

Figure 7 is a flowchart illustrating the processing in the pattern judgement unit 522, which constitutes the temperature selection unit 520 shown in Figure 3. Each functional unit is formed by the fact that a CPU executes a program in the computer provided in the present battery control device.

Upon start of processing, in its Step S521, the pattern judgement unit 522 reads the actual charge/discharge current I that flows for actual charging/discharging, the measured voltage Vm, and the estimated voltage Ve as synchronous data and determines the voltage difference ΔV, which is the value obtained by subtracting the measured voltage Vm from the estimated voltage Ve. The judgement and processing by the pattern judgement unit 522 then branch according to the value of the actual charge/discharge current I in Step S522. If the absolute value of the current is smaller than the predetermined value Ith, i.e., the judgement is NO, the process returns to S521.

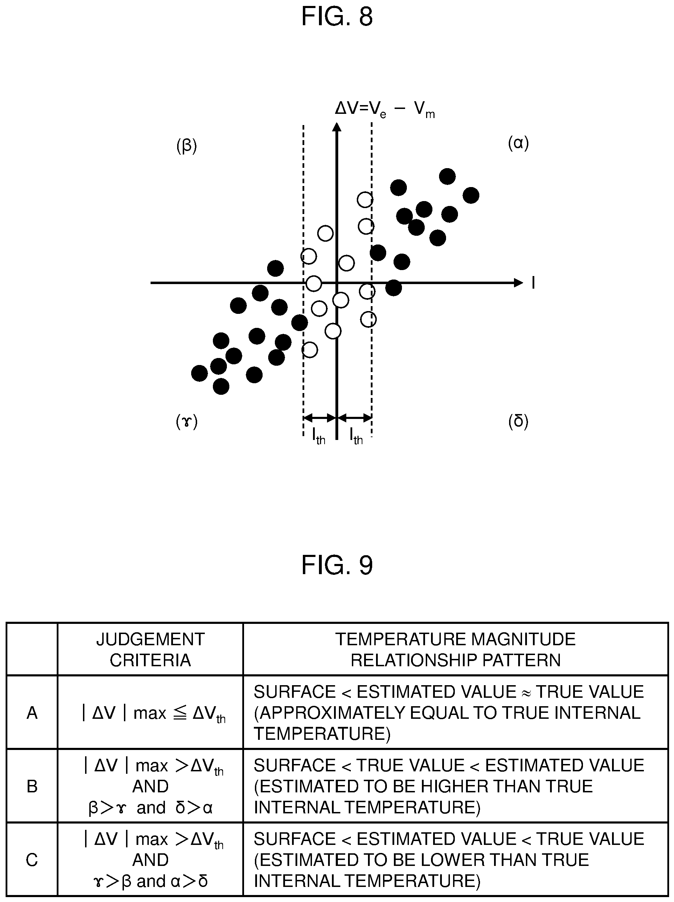

On the contrary, if the current is equal to or larger than Ith in Step S522, the pattern judgement unit 522 proceeds to Step S523 to accumulate a synchronous dataset of I and the voltage difference ΔV. The pattern judgement unit 522 then proceeds to Step S524 to check the number of pieces of accumulated data. As described below with reference to Figure 8, in Step S524, if the number of data points N is the predetermined number Nth or more, the pattern judgement unit 522 proceeds to S525, and if it is less than Nth returns to S521.

Figure 8 is a graph schematically illustrating the processing in the pattern judgement unit 522 shown in Figure 4. As shown in Figure 8, division into four areas: areas α to δ shown in Figure 8 is performed according to the positive/negative signs of the actual charge/discharge current I and the voltage difference ΔV. The area α represents the case where both the positive/negative signs of the voltage difference ΔV and the actual charge/discharge current I are positive. The area β represents the case where the actual charge/discharge current I is negative and the voltage difference ΔV is positive.

In Step S525, for each of the Nth datasets, the pattern judgement unit 522 performs classification into four areas α to δ shown in Figure 8, according to the combination of the positive/negative signs of the actual charge/discharge current I and voltage difference ΔV and the degree of unevenness of plot position distribution, and counts the number of datasets for each.

In Figure 8, if the absolute value of the current is less than Ith, it is plotted as a white circle and this is not counted as a data point. When the total number of black circles where the absolute value of the current is equal to or larger than Ith reaches Nth, the counting ends. Thus, the pattern judgement unit 522 finishes the counting when the number of black circles reaches Nth. Note that the graph in Figure 8 is merely used for the sake of convenience of explanation, and the calculation process in the computer need not be visible through the image display or the like, but is achievable by executing a program involving threshold-based judgement as explained with reference to Figure 8.

Returning to the flow shown in Figure 7, in Step S526, the pattern judgement unit 522 reads pattern information from the pattern holding unit 523. The temperature pattern information held in the pattern holding unit 523 will be described below with reference to Figure 9.

In S525, the pattern judgement unit 522 selects one maximum value |ΔV|max of the absolute value of the voltage difference ΔV included in each of the Nth datasets concurrently with the aforementioned counting. Further, in S525, the pattern judgement unit 522 transmits the breakdown of the Nth datasets that have been classified into the areas α to δ in Figure 8 and then counted, and the information on |ΔV|max to the pattern holding unit 523.

In S526, the pattern holding unit 523 determines the magnitude relationship pattern according to the aforementioned information transmitted from the pattern judgement unit 522, and returns the determined temperature pattern to the pattern judgement unit 522. With the assistance of the pattern holding unit 523, the pattern judgement unit 522 determines magnitude relationship patterns A to C according to the aforementioned information described with reference to Figures 6 to 9 in S525 and S526.

Figure 9 is a table illustrating data held by the pattern holding unit 523, which constitutes the temperature selection unit 520 shown in Figures 1 to 4. As shown in Figure 9, the pattern holding unit 523 contains judgement criteria for determining which of the following cases applies to the temperature information T of the assembled battery 110: the case where the estimated internal temperature Ti has been estimated to be higher or lower than the actual internal temperature Tt, and the case where Ti ≈ Tt which means that a value that almost coincides has been estimated.

For example, when the number of plot points in the area β is greater than that in the area γ and the number of plot points in the area δ is greater than 1, the pattern judgement unit 522 judges that it is the pattern A. The pattern conditions for such judgement are stored in the pattern holding unit 523. In Step S527, the pattern judgement unit 522 judges the pattern based on the results of checking against the pattern conditions in the pattern holding unit 523.

In Step S527, the pattern judgement unit 522 judges whether the Nth datasets that have been classified into the areas α to δ shown in Figure 8 and then counted correspond to which of the patterns A to C shown in Figure 9. In step S528, according to the pattern judged in the previous step S527, the pattern judgement unit 522 sends an output request to the temperature output unit 524, that is, an output request dependent on each temperature magnitude relationship pattern.

Figure 9 shows examples of temperature patterns and judgement criteria held by the pattern holding unit 523. The first pattern A holds true for the case where the maximum absolute value $|\Delta V|$max of the voltage difference $\Delta V$ is equal to or smaller than a predetermined value (threshold) $\Delta V$th.

The voltage difference $\Delta V$ is the voltage difference between the actual measured voltage and estimated voltage of the battery, and the smaller this value is, the closer to the true value the internal temperature is input to the CCV calculation unit 521. In other words, sufficiently small $|\Delta V|$max means that the internal temperature calculation unit 510 is accurately estimating the internal temperature, regardless of the breakdown of the areas $\alpha$ to $\delta$ of the Nth datasets.

In Figure 9, the pattern B holds true for the case where $|\Delta V|$max is greater than the predetermined value $\Delta V$th, and the breakdown of the number of data points is that the number of data points in the area $\beta$ is greater than that in the area y, and the number of data points in the area $\delta$ is greater than that in the area $\alpha$. In this case, since $|\Delta V|$max is greater than the predetermined value $\Delta V$th, it is judged that there is a deviation more than a certain level between the estimated internal temperature Ti and the true internal temperature Tt. Further, it is visible that the number of data points is concentrated in the areas $\beta$ and $\delta$ and unevenly distributed toward the bottom right if plotted in Figure 8 (not shown in the drawing).

This means that the positive/negative sign of the actual charge/discharge current I and the positive/negative sign of the voltage difference $\Delta V$ are often opposite. This is the case when the estimated internal temperature Ti is deviated toward the direction higher than the true internal temperature Tt, as it was explained with reference to Figure 6. Accordingly, the pattern of temperature magnitude relationship in the pattern B in Figure 9 is surface temperature Ts < true internal temperature Tt < estimated internal temperature Ti.

Referring to Figure 9, in the pattern C which is the opposite case to the pattern B above, the number of data points is concentrated in the area $\alpha$ and the area y$\gamma$ and as illustrated in Figure 8, it is visible that the plot points are unevenly distributed toward the upper right. In other words, the positive/negative sign of the actual charge/discharge current I and the positive/negative sign of the voltage difference $\Delta V$ are often identical; therefore, the estimated internal temperature Ti is deviated toward the direction lower than the true internal temperature Tt, as it was explained with reference toFigure 6(1). Hence, the temperature pattern shown in the pattern C in Figure 9 is surface temperature Ts < estimated internal temperature Ti < true internal temperature Tt.

Returning to the flow in Figure 7, in Step S526, the pattern judgement unit 522 receives pattern information from the pattern holding unit 523. The process then proceeds to Step S527 to judge whether or not the pattern information received in the previous step is the same as the pattern received during the previous processing.

In step S527, for example, if the pattern A has been received during the previous processing and the pattern received this time is also the pattern A, the pattern judgement unit 522 proceeds to Step S528. On the contrary, if the pattern received this time is other than the pattern A, the pattern is different from the previous one so the pattern judgement unit 522 proceeds to Step S529C.

In other words, when the same pattern has been received two or more times in a row, it is judged that the magnitude of the deviation between the estimated internal temperature Ti and the true internal temperature Tt and the direction of the deviation are stable, and a temperature switching command is sent to the temperature output unit 524 as described below. In the present battery control device, the condition for proceeding from Step S527 to Step S528 is that the same pattern is received two or more times in a row, but the number of times may be increased or decreased as appropriate, for example, to three or more times in a row or four or more times in a row.

In Step S528, the pattern judgement unit 522 judges whether the temperature pattern received from the pattern holding unit 523 in this processing is the pattern B or not, and branches the process. If the received pattern is the pattern B, the process proceeds to Step S529A where a command to select the surface temperature Ts is transmitted to the temperature output unit 524. Here, if the temperature output unit 524 has already selected the surface temperature Ts when receiving the command, it continues to select and output the surface temperature Ts.

On the contrary, if the temperature output unit 524 has selected the estimated internal temperature Ti, the selected temperature is switched from the estimated internal temperature Ti to the surface temperature Ts as commanded by the pattern judgement unit 522 and is then output. If the pattern received this time is found to be not the pattern B in Step S528, the pattern judgement unit 522 proceeds to Step S529B and transmits a command to select the estimated internal temperature Ti to the temperature output unit 524. The following operation is similar to that of Step S529A.

When proceeding from the previous Step S527 to Step S529C, the pattern judgement unit 522 does not issue a command to the temperature output unit 524 to switch the temperature selection because the temperature pattern received from the pattern holding unit 523 is different each time and the judgement is not stable. For this reason, in this case, the temperature output unit 524 continues to select the temperature that has been previously selected among the surface temperature Ts and the estimated internal temperature Ti.

In Step S528, if the estimated internal temperature Ti in the pattern B calculated is higher than the true internal temperature Tt, the pattern judgement unit 522 causes the battery surface temperature Ts, which is lower than the internal temperature, to be selected; otherwise, the estimated internal temperature Ti is to be selected. The aim of this operation is to prioritize safer operation of the battery. As for the temperature information T to be referred to during calculations related to the input/output performance of the battery, such as allowable power calculations, the higher the estimated temperature, the higher the risk for battery management.

For this reason, referring to Figure 9, when the pattern of the temperature magnitude relationship is judged to be the pattern B, the estimated internal temperature Ti may be higher than the true internal temperature Tt. Thus, as the temperature information T used for allowable power calculation and the like, the surface temperature Ts, which can be regarded as lower than the true internal temperature Tt, is safer to use for control.

Returning to Figure 4, the temperature output unit 524 selects either the estimated internal temperature Ti or the actually measured surface temperature Ts according to the output request dependent on each temperature magnitude relationship pattern sent from the aforementioned pattern judgement unit 522, and outputs the temperature information T to the higher-level calculation unit.

According to the criteria for selecting the temperature information T, in the case of the pattern B where the estimated internal temperature Ti is calculated higher than the true internal temperature Tt, the surface temperature Ts, which is lower than the internal temperature Tt, is selected, while in the other patterns A and C, the estimated internal temperature Ti is selected. This is because estimating a higher temperature than the true internal temperature Tt is riskier for battery management.

As described above, the present battery control device can achieve both safety of battery control and performance of battery input/output characteristics by selecting a more appropriate temperature for battery control, the estimated internal temperature Ti or the surface temperature Ts, as the temperature information T used for various types of battery control.

Note that the battery 110 in the storage battery system 100 is not necessarily a lithium-ion secondary battery, but is applicable to any types of storage battery systems 100 composed of chargeable and dischargeable energy storage elements, such as nickel-metal hydride batteries, lead-acid batteries, electric double layer capacitors, and lithium-ion capacitors.

Application of the present invention makes it possible to achieve suppression of battery cell degradation and longer service life in systems and methods for controlling batteries, contributing to the manufacture, sale, and maintenance of battery control systems, and improving the reliability of the storage battery system 100.

[Supplemental Information]

Power storage batteries are used in a wide range of fields, typified by mobile terminals, for ensuring the stability of power system linkages. In recent years, battery-powered vehicles, such as electric vehicles and hybrid vehicles, have been attracting attention as a measure to combat fossil fuel depletion and reduce emissions, especially $CO_2$.

The storage battery system 100 in these systems includes a battery control device that detects battery voltage, temperature, and current, calculates, based on these, state quantities such as the battery charge rate, and determines current-voltage control values for the battery, as it has been described with reference to Figure 1. The present battery control device is suitable for the single batteries 111, the storage battery system 100, and the power control system for their charging and discharging, which are used in hybrid vehicle control systems and the like.

The assembled battery control unit 150 in the present battery control device includes calculation of SOH (battery's degradation rate, indicator of the health and degradation state, and ratio of the fully charged capacity (Ah) at the time of degradation to the fully charged capacity (Ah) in the initial stage, expressed in %), SOC (remaining battery capacity, (remaining capacity (Ah)/fully charged capacity (Ah) × 100) %), OCV (open circuit voltage), and the allowable power calculation unit.

In actuality, the true internal temperature Tt cannot be measured in real time, but the hypothetical true internal temperature Tt is used for convenience. First, the equivalent circuit parameters of a single battery 111 described above, Ro, Rp, and τ, are measured experimentally. At this time, the single battery 111 to be measured is stored for a sufficiently long time in a thermostatic chamber or the like capable of holding a predetermined temperature, and the single battery 111 is charged and discharged under conditions in which the temperature can be considered to be the same from the battery surface to the center, thereby obtaining each parameter. These are treated as if they were the various equivalent circuit parameters at the true internal temperature Tt.

Many battery control parameters, represented by direct current resistance (DCR), are dependent on battery temperature. This DCR is known to increase with decreasing battery temperature. This means that the temperature dependence of DCR causes the allowable power, for example, to drop as the battery temperature decreases.

Allowable power is the maximum power value that can be output by a battery and set for the purpose of battery protection, and a decrease in allowable power at low temperatures is a problem that deteriorates battery performance in cold weather. The storage battery system 100 calculates the allowable power using temperature information (battery temperature) T as input. This temperature information T is required to be accurate.

If this temperature information T is inaccurate, it will be difficult to achieve both safe use and performance of the battery 110. To be specific, an unnecessarily excessive safety margin set for the allowable power may cause a failure in which, with the potential performance, the capabilities that should be offered cannot be offered. On the contrary, failures may also be caused by over-relaxing the allowable power limit which is set to the minimum for the reasons of battery service life and security.

As described above, the pattern judgement unit 522 judges the temperature pattern, referring to the pattern information held in the pattern holding unit 523. In the present battery control device, the judgement criteria shown in Figure 9 are used to identify temperature magnitude relationship patterns (temperature patterns) and judge which of the first to third magnitude relationship patterns A to C it matches. In particular, judgement is made based on the state and behavior of the battery shown in Figure 6 by the judgement scheme shown in Figures 7 to 9; however, this is not necessarily the case.

That judgement scheme is a type of pattern recognition. Pattern recognition is a type of natural information processing that selects and extracts objects with certain rules and meanings from data containing miscellaneous information, such as images and voice. This processing can be handled by artificial intelligence (AI). In contrast, the judgement scheme shown in Figures 7 to 9 can be easily and reliably accomplished using a program that mainly performs threshold selection and logical judgement, which is simpler than AI.

Note that the functions of each calculation unit and the like are formed when the CPU of a computer provided in the present battery control device reads a calculation program from the memory according to the purpose and executes it. For such a computer, a one-chip microcomputer is sufficient, but a personal computer can also be used, or a part of a computer for other purposes can be used.

The present battery control device can be summarized as follows.

[1] As shown in Figures 1, 3 and 4, the present battery control device calculates the allowable power of the battery, inputting at least temperature information (battery temperature) T. The present battery control device includes a temperature detection unit 125, an internal temperature calculation unit 510, and a temperature selection unit 520.

The temperature detection unit 125 detects the surface temperature Ts of the battery 110 by actual measurement. The internal temperature calculation unit 510 estimates the estimated internal temperature Ti of the battery 110 by calculation in place of actual measurement and outputs the estimated internal temperature Ti that has been estimated. The temperature selection unit 520 selects either the surface temperature Ts or the estimated internal temperature Ti to apply to control.

The temperature selection unit 520 selects either the surface temperature Ts or the estimated internal temperature Ti based on the following information. At that stage of selection, the current surface temperature Ts, the estimated internal temperature TiTt, the estimated internal temperature Ti, and the mutual magnitude relationship are judged. The information used for this judgement has the following first and second requirements.

The first requirement is information about the magnitude relationship between the true internal temperature Tt, surface temperature Ts, and estimated internal temperature Ti of the battery 110. The second requirement is data in which the measured voltage (actual charge/discharge voltage) Vm, the measured current (actual charge/discharge current) I, and the estimated voltage Ve estimated from the battery 110's state information, which are related to the battery 110 at a certain clock time, are correlated with each other, and is information in which that data has been accumulated for more than one clock time.

Such information can be tied to a compilation of information about specification values, experimental values, and empirical rules of the battery 110, and can be applied as control judgement criteria to the present battery control device. Based on this information, the present battery control device calculates the allowable power of the battery 110. The objective of this allowable power is achieved with a calculation program that enables the battery 110 to be safely used and offer its performance at the same time.

If it is determined that it is appropriate to apply the surface temperature Ts according to the information accumulated to determine the state of the battery 110 at a certain clock time, the present battery control device with the configuration described above operates in such a way to perform control safely. Meanwhile, if it is determined that it is appropriate to apply the estimated internal temperature Ti, depending on the state of the battery 110 at another clock time, the present battery control device operates in such a way to perform control for offering best performance.

As described above, the present battery control device judges which of the directly measurable surface temperature Ts or the estimated internal battery temperature Ti that has been estimated is more appropriate in terms of control for use in the state detection calculation, based on the accumulated information, and switches the temperature information T to be used according to the situation, thereby allowing the battery 110 to be used safely and to offer its performance at the same time. In other words, the reliability of various state calculations using battery temperature information T can be improved, the original performance can be offered, and the battery can be operated safely.

[2] In the present battery control device of [1] above, the temperature selection unit 520 shown in Figures 3 and 4 includes a pattern holding unit 523, a pattern judgement unit 522, and a temperature output unit 524. The pattern holding unit 523 holds any of the first to third magnitude relationship patterns A to C selected based on the information accumulated for more than one clock time.

The pattern judgement unit 522 checks the current magnitude relationship of the battery against the first to third magnitude relationship patterns held in the pattern holding unit 523 to determine which of them it matches. The temperature output unit 524 selects and outputs temperature information T dependent on the result of the judgement by the pattern judgement unit 522.

The temperature selection unit 520 selects either the surface temperature Ts or the estimated internal temperature Ti for the temperature information T to be applied to calculate the allowable power of the battery. In order to select optimally, the temperature selection unit 520 defines the first to third magnitude relationship patterns A to C as shown in Figure 9 for the magnitude relationship between three types of temperature: the true internal temperature Tt of the battery, the surface temperature Ts, the estimated internal temperature Ti, under the condition that surface temperature Ts < estimated internal temperature Ti.

Referring to Figure 9, in the first magnitude relationship pattern A, the magnitude relationship between the aforementioned three types of temperature is estimated to be Ti ≈ Tt under the condition that surface temperature Ts < estimated internal temperature Ti. In the second magnitude relationship pattern B, the magnitude relationship between the aforementioned three types of temperature is estimated to be Ts < Tt < Ti. In the third magnitude relationship pattern C, the magnitude relationship between the aforementioned three types of temperature is estimated to be Ts < Ti < Tt.

When it is judged that the first magnitude relationship pattern A or the third magnitude relationship pattern C holds true, the temperature output unit 524 outputs the estimated internal temperature Ti. When it is judged that the second magnitude relationship pattern B holds true, the temperature output unit 524 outputs the surface temperature Ts. With the present battery control device of [2], the judgement scheme shown in Figures 7 and 9 makes judgement based on the battery's state and behavior shown in Figure 6. This judgement scheme can be achieved reliably and easily using a program mainly involving threshold selection and logical judgement, which is simpler than AI.

[3] As shown in Figure 9, in the present battery control device of [2] above, the first magnitude relationship pattern A held in the pattern holding unit 523 holds true for the case where the maximum absolute value |ΔV|max of the difference between the measured voltage Vm and the estimated voltage Ve in the information obtained by accumulation for more than one clock time is equal to or smaller than the predetermined value ΔVth. The second magnitude relationship pattern B and the third magnitude relationship pattern C hold true for the case where the maximum absolute value |ΔV|max of the difference between the measured voltage Vm and the estimated voltage Ve in the information obtained by accumulation for more than one clock time exceeds the predetermined value ΔVth.

With the present battery control device of [2], if the pattern judgement unit 522 judges that the first magnitude relationship pattern A (where the plot points are unevenly distributed near the actual charge/discharge current I axis in the graph in Figure 8) holds true, the difference between the measured voltage Vm and the estimated voltage Ve is small, so that the battery temperature information T is highly accurate, based on which favorable control is performed and the battery is judged to be in good condition.

Meanwhile, if the second magnitude relationship pattern B and the third magnitude relationship pattern C hold true, it is judged that the battery is deteriorating and requires control that takes into consideration the decreasing accuracy of the temperature information T. In other words, this makes it possible to clearly grasp the state of the battery.

Note that the first magnitude relationship pattern A (flat in Figure 8) held in the pattern holding unit 523 also serves as a reference for discriminating between the second magnitude relationship pattern B (opposite to Figure 8, with plot points unevenly distributed toward the bottom right) and the third magnitude relationship pattern C (exactly as in Figure 8, with plot points unevenly distributed toward the upper right), thereby facilitating and clarifying the discrimination.

[4] In the present battery control device of [3] above, the second magnitude relationship pattern B (opposite to Figure 8 and toward the bottom right) and the third magnitude relationship pattern C (exactly as in Figure 8 and toward the upper right) held in the pattern holding unit 523 are judged according to the combination of the magnitude relationship between the estimated voltage Ve and the measured voltage Vm in the information obtained by accumulation for more than one clock time, and the polarity of the measured current (actual charge/discharge current) I. As shown in Figure 8, for example, if 37 pieces of data are acquired and plotted every second, a certain level of accuracy can be ensured in the judgement by the pattern judgement unit 522.

[5] As shown in Figure 6(2), as for the present battery control device of [4] above, the second magnitude relationship pattern B (opposite to Figure 8 and toward the bottom right) holds true when the estimated voltage Ve tends to be lower than the measured voltage Vm during charging of the measured current (actual charge/discharge current) I, and when the estimated voltage Ve tends to be higher than the measured voltage Vm during discharging of the measured current (actual charge/discharge current) I.

In the present battery control device of [5] above, the pattern judgement unit 522 judges whether the temperature pattern is toward the upper right as shown in Figure 8 or not, referring to the pattern information held in the pattern holding unit 523. At the time, the judgement scheme shown in Figures 7 to 9 is used to judge from the state and behavior of the battery shown in Figure 6. The judgement scheme can judge reliably and easily that the pattern B (Figure 9), which is opposite to Figure 8 and toward the upper right, holds true by a program that mainly performs threshold selection and logical judgement, which is simpler than AI.

[6] As shown in Figure 6(1), as for the present battery control device of [4] above, the third magnitude relationship pattern C (exactly as in Figure 8 and toward the upper right) holds true when the estimated voltage Ve tends to be higher than the measured voltage Vm during charging of the measured current (actual charge/discharge current) I, and when the estimated voltage Ve tends to be lower than the measured voltage Vm during discharging of the measured current (actual charge/discharge current) I.

As for the present battery control device of [5] above as well, the judgement scheme using a program that mainly performs threshold selection and logical judgement, which is simpler than AI, can judge reliably and easily that the pattern C (Figure 9), which is exactly as in Figure 8 and toward the upper right, holds true.

[Reference Signs List]

100: Storage battery system, 110: Assembled battery (battery), 111: Single battery, 112a, 112b (112 if distinction is not necessary): Single battery group, 120: Single battery management unit, 121a, 121b (collectively 121): Single battery control unit, 122: Voltage detection circuit, 123: Control circuit, 124: Signal input/output circuit, 125: Temperature detection unit, 130: Current detection unit, 140: Voltage detection unit, 150: Assembled battery control unit, 151: SOC calculation unit, 160: Signal communication means, 170: Insulator, 200: Vehicle control unit, 300 to 330: Relay, 400: Inverter, 410: Motor generator, 420: Charger, 500: Temperature information processing unit, 510: Internal temperature calculation unit, 520: Temperature selection unit, 521: CCV calculation unit, 522: Pattern judgement unit, 523: Pattern holding unit, 524: Temperature output unit, A to C: First to third magnitude relationship patterns, I: Actual charge/discharge current (measured current), T: Temperature information, $T_i$: Estimated internal temperature, $T_t$: True internal temperature, $T_s$: Surface temperature, $V_e$: Estimated charge/discharge voltage (estimated voltage), $V_m$: Actual charge/discharge voltage (measured voltage)

**Claims**

1. A battery control device that calculates at least temperature information T to calculate allowable power of a battery, the battery control device comprising:

   a surface temperature detection unit that actually measures a surface temperature $T_s$ of the battery;
   an internal temperature calculation unit that estimates an estimated internal temperature $T_i$ of the battery in place of the actual measurement; and
   a temperature selection unit that selects and outputs either the surface temperature $T_s$ or the estimated internal temperature $T_i$ as the temperature information T, wherein
   based on information accumulated for more than one clock time, the information being taken at a certain clock time and being of an actual charge/discharge voltage $V_m$ of the battery, an actual charge/discharge current I of the battery, and an estimated charge/discharge voltage $V_e$ that is estimated from state information of the battery, the temperature selection unit determines
   a magnitude relationship between a true internal temperature $T_t$, the surface temperature $T_s$, and the estimated internal temperature $T_i$ for the current battery, and
   applies the selected temperature information T to control according to a result of the judgement.

2. The battery control device according to claim 1, wherein

   in the temperature selection unit,
   under a condition that the surface temperature $T_s$ < the estimated internal temperature $T_i$,
   first to third magnitude relationship patterns are defined for a magnitude relationship between the true internal temperature $T_t$ of the battery, the surface temperature $T_s$, and the estimated internal temperature $T_i$,
   in the first magnitude relationship pattern, the estimated internal temperature $T_i$ and the true internal temperature $T_t$ of the battery are estimated to be equal,
   in the second magnitude relationship pattern, the magnitude relationship between the true internal temperature $T_t$ of the battery, the surface temperature $T_s$, and the estimated internal temperature $T_i$ is estimated to be $T_s < T_t < T_i$,
   in the third magnitude relationship pattern, the magnitude relationship between the true internal temperature $T_t$ of the battery, the surface temperature $T_s$, and the estimated internal temperature $T_i$ is estimated to be $T_s < T_i < T_t$,
   the temperature selection unit includes:

   a pattern holding unit that holds any one of the first to third magnitude relationship patterns selected based on the information obtained by accumulation for more than one clock time;

a pattern judgement unit that judges which of the first to third magnitude relationship patterns held in the pattern holding unit a current magnitude relationship of the battery matches; and
a temperature output unit that selects and outputs the temperature information T according to a result of the judgement by the pattern judgement unit, and

the temperature output unit
outputs the estimated internal temperature Ti if the first or third magnitude relationship pattern is judged to hold true, and
outputs the surface temperature Ts if the second magnitude relationship pattern is judged to hold true.

3. The battery control device according to claim 2, wherein

the first magnitude relationship pattern held in the pattern holding unit holds true for the case where a maximum absolute value $|\Delta V|$max of a difference between the actual charge/discharge voltage Vm and the estimated charge/discharge voltage Ve in the information obtained by accumulation for more than one clock time is equal to or smaller than a predetermined value $\Delta$Vth, and
the second magnitude relationship pattern and the third magnitude relationship pattern hold true for the case where the maximum absolute value $|\Delta V|$max of the difference between the actual charge/discharge voltage Vm and the estimated charge/discharge voltage Ve in the information obtained by accumulation for more than one clock time exceeds the predetermined value $\Delta$Vth.

4. The battery control device according to claim 3, wherein the second magnitude relationship pattern and the third magnitude relationship pattern held in the pattern holding unit are judged according to a combination of a magnitude relationship between the estimated charge/discharge voltage Ve and the actual charge/discharge voltage Vm in the information obtained by accumulation for more than one clock time, and a polarity of the actual charge/discharge current I.

5. The battery control device according to claim 4, wherein the second magnitude relationship pattern holds true when the estimated charge/discharge voltage Ve tends to be lower than the actual charge/discharge voltage Vm during charging of the actual charge/discharge current I, and when the estimated charge/discharge voltage Ve tends to be higher than the actual charge/discharge voltage Vm during discharging of the actual charge/discharge current I.

6. The battery control device according to claim 4, wherein the third magnitude relationship pattern holds true when the estimated charge/discharge voltage Ve tends to be higher than the actual charge/discharge voltage Vm during charging of the actual charge/discharge current I, and when the estimated charge/discharge voltage Ve tends to be lower than the actual charge/discharge voltage Vm during discharging of the actual charge/discharge current I.

# FIG. 1

FIG. 2

FIG. 3

EP 4 503 259 A1

FIG. 4

EP 4 503 259 A1

# FIG. 5

FIG. 6

(1) $T_i < T_t$

VOLTAGE

MEASURED VOLTAGE $V_m$

ESTIMATED VOLTAGE $V_e$

TIME

VOLTAGE DIFFERENCE $\Delta V$

+ -

0 $V_e - V_m$

TIME

CURRENT

+ -

CHARGE

0

DIS-CHARGE

TIME

(2) $T_t < T_i$

VOLTAGE

MEASURED VOLTAGE $V_m$

ESTIMATED VOLTAGE $V_e$

TIME

VOLTAGE DIFFERENCE $\Delta V$

- +

0 $V_e - V_m$

TIME

CURRENT

+ -

CHARGE

0

DIS-CHARGE

TIME

# FIG. 7

START

**S521**
READ CURRENT
I, $V_m$, $V_e$ SYNCHRONOUS
DATA TO CALCULATE ($\Delta V = V_e - V_m$)

**S522**
$|I| \geqq I_{th}$ ?  — NO

YES **S523**
ACCUMULATE DATA (I, $\Delta V$)

**S524**
DATA POINTS $N \geq N_{th}$ ?  — NO

YES **S525**
COUNT AND TRANSMIT DATA
TRANSMITTED TO PATTERN HOLDING
UNIT

**S526**
RECEIVE PATTERN INFORMATION
FROM PATTERN HOLDING UNIT

**S527**
SAME PATTERN AS
PREVIOUSLY RECEIVED
ONE?  — NO

YES **S528**
PATTEN B RECEIVED?

YES — **S529A**
Ts SELECTION
COMMAND

NO **S529B**
Ti SELECTION
COMMAND

**S529C**
NO SELECTION
SWITCH
COMMAND

END

FIG. 8

FIG. 9

|   | JUDGEMENT CRITERIA | TEMPERATURE MAGNITUDE RELATIONSHIP PATTERN |
|---|---|---|
| A | $\lvert \Delta V \rvert \, max \leqq \Delta V_{th}$ | SURFACE < ESTIMATED VALUE ≈ TRUE VALUE (APPROXIMATELY EQUAL TO TRUE INTERNAL TEMPERATURE) |
| B | $\lvert \Delta V \rvert \, max > \Delta V_{th}$ AND $\beta > \gamma$ and $\delta > \alpha$ | SURFACE < TRUE VALUE < ESTIMATED VALUE (ESTIMATED TO BE HIGHER THAN TRUE INTERNAL TEMPERATURE) |
| C | $\lvert \Delta V \rvert \, max > \Delta V_{th}$ AND $\gamma > \beta$ and $\alpha > \delta$ | SURFACE < ESTIMATED VALUE < TRUE VALUE (ESTIMATED TO BE LOWER THAN TRUE INTERNAL TEMPERATURE) |

23

## INTERNATIONAL SEARCH REPORT

International application No.

**PCT/JP2023/013710**

### A. CLASSIFICATION OF SUBJECT MATTER

*H01M 10/48*(2006.01)i; *B60L 3/00*(2019.01)i; *B60L 58/24*(2019.01)i
FI: H01M10/48 301; B60L3/00 S; B60L58/24; H01M10/48 P

According to International Patent Classification (IPC) or to both national classification and IPC

### B. FIELDS SEARCHED

Minimum documentation searched (classification system followed by classification symbols)

H01M10/48; B60L3/00; B60L58/24

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2011/045853 A1 (HITACHI, LTD.) 21 April 2011 (2011-04-21) paragraphs [0020]-[0024], fig. 1-4 | 1-6 |
| A | JP 2021-9103 A (VEHICLE ENERGY JAPAN INC) 28 January 2021 (2021-01-28) paragraphs [0019]-[0125], fig. 1 | 1-6 |
| A | WO 2017/159031 A1 (SONY CORPORATION) 21 September 2017 (2017-09-21) paragraphs [0059]-[0062], fig. 1 | 1-6 |

☐ Further documents are listed in the continuation of Box C.   ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **06 June 2023** | **13 June 2023** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (January 2015)

INTERNATIONAL SEARCH REPORT
Information on patent family members

International application No.

**PCT/JP2023/013710**

| Patent document cited in search report | | | Publication date (day/month/year) | Patent family member(s) | | | Publication date (day/month/year) |
|---|---|---|---|---|---|---|---|
| WO | 2011/045853 | A1 | 21 April 2011 | US | 2012/0256569 | A1 | |
| | | | | paragraphs [0055]-[0059], fig. 1-4 | | | |
| | | | | CN | 102576914 | A | |
| JP | 2021-9103 | A | 28 January 2021 | (Family: none) | | | |
| WO | 2017/159031 | A1 | 21 September 2017 | US | 2019/0036373 | A1 | |
| | | | | paragraphs [0076]-[0079], fig. 1 | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011222133 A

- JP 2014531711 W